# EUROPEAN PATENT APPLICATION

(11) **EP 2 075 851 A2**
(43) Date of publication of application: **01.07.2009**
(21) Application number: 08254138.4
(22) Date of filing: 23.12.2008
(51) Int. Cl.: H01L 31/0392, H01L 31/048, H01L 27/142

(54) **Solar cell module and method for manufacturing solar cell module**

(30) Priority: 27.12.2007 JP 2007338197
(71) Applicant: SANYO Electric Co., Ltd., Moriguchi-shi Osaka 570-8677 (JP)
(72) Inventor: Sekimoto, Takeyuki , Sanyo Electric Co., Ltd., Osaka 570-8677 (JP); Yagiura, Toshio , Sanyo Electric Co., Ltd., Osaka 570-8677 (JP); Yata, Shigeo , Sanyo Electric Co., Ltd., Osaka 570-8677 (JP)
(74) Representative: Calderbank, Thomas Roger

(57) **Abstract**

In the solar cell element 2, the second semiconductor layer 24 includes the first extension part 241 which is extended toward and in contact with the first semiconductor layer 22. The extension part 241 is provided along the element separation groove 6 and the power generation region separation groove 7.

## Description

This application is based upon and claims the benefit of priority from prior Japanese Patent Application No.2007-338197, filed on December 27, 2007: the entire contents of which are incorporated herein by reference.

The present invention relates to a solar cell module in which a first electrode layer, a first semiconductor layer, a transparent conductive layer, a second semiconductor layer and a second electrode layer are sequentially stacked on a substrate, and also relates to a manufacturing method thereof.

A thin-film solar cell module generally has a first electrode layer, a first semiconductor layer, a transparent conductive layer, a second semiconductor layer and a second electrode layer, which are sequentially stacked on a substrate. In such a solar cell module, the first electrode layer, the first semiconductor layer, the transparent conductive layer, the second semiconductor layer and the second electrode layer are separated into a power generation region contributing to power generation and a non-power generation region surrounding the power generation region by a power generation region separation groove penetrating those five layers.

In the power generation region, a plurality of solar cell elements having a rectangular shape in planar view are lined up in a short side direction. The plurality of solar cell elements are separated from each other by element separation grooves penetrating the first semiconductor layer, the transparent conductive layer, the second semiconductor layer and the second electrode layer. Specifically, each of the plurality of solar cell elements provided inside of the power generation region is formed between a pair of the element separation grooves.
The plurality of solar cell elements as described above are electrically connected each

other. Specifically, a second electrode layer in one solar cell element has a connection part which is in contact with a first electrode layer in another solar cell element adjacent to the one solar cell element In one side of the pair of element separation grooves, such a connection part is extended toward the first electrode layer in the another solar cell element while covering a side surface of the transparent conductive layer. (see Japanese Patent Application Publication No. 2006-313872).

The solar cell module is generally used outside over a long period of time. Therefore, the solar cell module desirably has moisture resistance for maintaining high photoelectric conversion efficiency even if moisture enters inside of the solar cell module.

However, in the above solar cell module, the side surface of the transparent conductive layer is exposed on the side surface of the solar cell element, except for the portion covered with the connection part in the second electrode layer. Thus, the transparent conductive layer may be deteriorated when moisture that has entered the solar cell module reaches the transparent conductive layer. When the transparent conductive layer is deteriorated, photogenerated carriers generated in each of the solar cell elements are reduced. Thus, there is a problem that the photoelectric conversion efficiency of the solar cell module is decreased.

The present invention has been made in the light of the foregoing problems. It is an object of the present invention to provide a solar cell module capable of suppressing deterioration in photoelectric conversion efficiency, and a manufacturing method thereof.

A first aspect of the present invention is a solar cell module in which a first electrode layer, a first semiconductor layer, a transparent conductive layer, a second semiconductor layer and a second electrode layer are sequentially stacked on a substrate. The solar cell module includes a plurality of solar cell elements surrounded by a penetration groove penetrating the first semiconductor layer, the transparent conductive layer, the second semiconductor layer and the second electrode layer. The second semiconductor layer in one solar cell element of the plurality of solar cell elements has an extension part which is extended toward the first semiconductor layer. The extension part covers at least a part of side surface of the transparent conductive layer, and is provided along the penetration groove.

A second aspect of the present invention according to the first aspect of the present invention is that the penetration groove is a pair of the element separation grooves provided on both sides of each of the plurality of solar cell elements. The second electrode layer in the one solar cell element includes a connection part connecting to the first electrode layer in another solar cell element adjacent to the one solar cell element. The connection part covers a side surface of the transparent conductive layer on one side of the pair of the element separation grooves, while the penetration groove may be another element separation groove of the pair of the element separation grooves.

A third aspect of the present invention according to the first aspect of the present invention is that the solar cell module further includes a power generation region including the plurality of solar cell elements and a non-power generation region surrounding the power generation region and being spaced apart from the power generation region. The penetration groove is a power generation region separation groove separating the power generation region from the non-power generation region. Moreover, the power generation region separation groove may penetrate the first electrode layer, the first semiconductor layer, the transparent conductive layer, the second semiconductor layer and the second electrode layer.

A fourth aspect of the present invention is a method for manufacturing a solar cell module in which a first electrode layer, a first semiconductor layer, a transparent conductive layer, a second semiconductor layer and a second electrode layer are sequentially stacked on a substrate, the solar cell module including a plurality of solar cell elements surrounded by a penetration groove penetrating at least the first semiconductor layer, the transparent conductive layer, the second semiconductor layer and the second electrode layer. The method includes the steps of: forming the first electrode layer and the first semiconductor layer sequentially on the substrate; forming the transparent conductive layer and the second semiconductor layer having an extension part which covers at least a part of the side surface of the sequentially; and forming the penetration groove along the extension part.

A fifth aspect of the present invention according to the fourth aspect of the present invention is that the step of forming the second semiconductor layer having the extension part may include the steps of: covering a part of the first semiconductor layer with a mask: forming the transparent conductive layer on the first semiconductor layer; removing the mask; and forming the second semiconductor layer on the first semiconductor layer exposed in a region where the mask has been removed.

A sixth aspect of the present invention according to the fourth aspect of the present invention is that the step of forming the second semiconductor layer having the extension part includes the steps of: forming the transparent conductive layer on the first semiconductor layer; removing a part of the transparent conductive layer; and forming the second semiconductor layer on the first semiconductor layer exposed in a region where the transparent conductive layer has been removed. In the drawings
Fig. 1 is a top view of a solar cell module 100 according to a first embodiment of the present invention.
Figs. 2A and 2B are cross-sectional views of the solar cell module 100 according to the first embodiment of the present invention (cross-sectional views along the lines A-A and B-B in Fig. 1, No. 1).
Figs. 3A and 3B are cross-sectional views of the solar cell module 100 according to the first embodiment of the present invention (cross-sectional views along the lines A-A and B-B in Fig. 1, No. 2).
Figs. 4A to 4E are views showing a method for manufacturing the solar cell module 100 according to the first embodiment of the present invention (No. 1).
Figs. 5A to 5D are views showing the method for manufacturing the solar cell module 100 according to the first embodiment of the present invention (No. 2).
Figs. 6A and 6B are views showing the method for manufacturing the solar cell module 100 according to the first embodiment of the present invention (No. 3).
Fig. 7 is a top view of a third layer 230.
Fig. 8 is a cross-sectional view of a solar cell module 100 according to a second embodiment of the present invention (a cross-sectional view along the line A-A in Fig. 1).
Fig. 9 is a cross-sectional view of a solar cell module 100 according to a third embodiment of the present invention (a cross-sectional view along the line A-A in Fig. 1).
Fig. 10 is a top view of a solar cell module 100 according to a fourth embodiment of the present invention.
Fig. 11 is a cross-sectional view of a solar cell 110 according to an example of the present invention.
Fig. 12 is a cross-seotional view of a solar cell 120 according to a comparative example of the present invention.
Fig. 13 is a graph showing changes with time in photoelectric conversion efficiency of the solar cells according to the example and the comparative example.

Next, with reference to the drawings, embodiments of the present invention will be described. Note that, in the following description of the drawings, the same or similar parts will be denoted by the same or similar reference numerals. However, it should be noted that the drawings are conceptual and ratios of respective dimensions and the like are different from actual ones. Therefore, specific dimensions and the like should be determined by taking into consideration the following description. Moreover, as a matter of course, also among the drawings, there are included portions in which dimensional relationships and ratios are different from each other.

### [First Embodiment]

### (Schematic Configuration of Solar Cell Module)

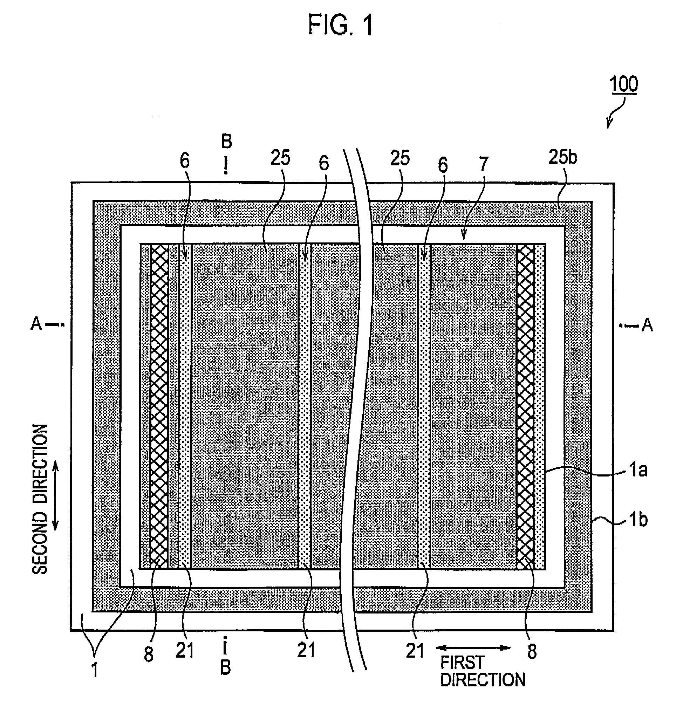

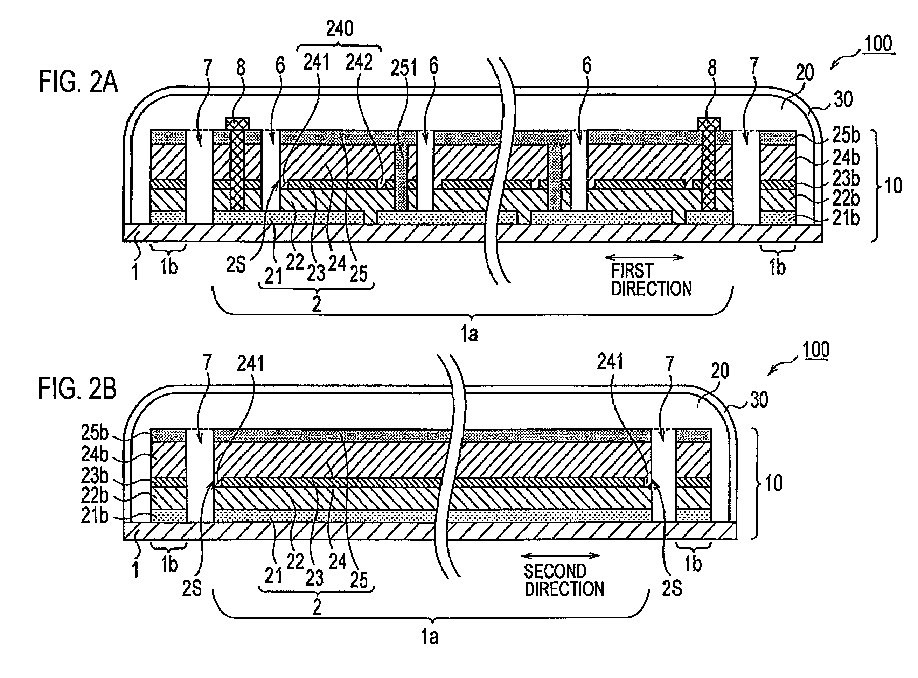

With reference to Fig. 1. a schematic configuration of a solar cell module 100 according to a first embodiment of the present invention will be described below. Fig. 1 is a top view of the solar cell module 100 according to the first embodiment of the present invention. Note that in Fig. 1, a filler 20 and a protector 30 are removed therefrom. Moreover, Figs. 2A and 2B are cross-sectional views of the solar cell module 100. Note that Fig. 2A is a cross-sectional view along the line A-A in Fig. 1 and Fig. 2B is a cross-sectional view along the line B-B in Fig. 1.

As shown in Figs. 1, 2A and 2B, the solar cell module 100 includes a solar cell 10, the filler 20 and the protector 30.

The solar cell 10 includes a power generation region 1a and a non-power generation region 1b surrounding the power generation region 1a and being spaced apart therefrom. A configuration of the solar cell will be described later.

The filler 20 is disposed between a plurality of solar cell elements 2 included in the solar cell 10 and the protector 30 so as to cover the plurality of solar cell elements 2. The filler 20 functions as an adhesive for bonding the solar cell 10 to the protector 30. Moreover, the filler 20 also functions as a buffer for buffering impact applied to the solar cell module 100. As the filler 20, a resin such as EVA. EEA. PVB. silicon, urethane, acrylic and epoxy can be used.

The protector 30 is disposed on the filler 20 to protect the solar cell 10. As the protector 30, PET, PEN, ETFE, PVDF, PCTFE, PVF, PC, acrylic, glass or the like can be used.

### (Configuration of Solar Cell)

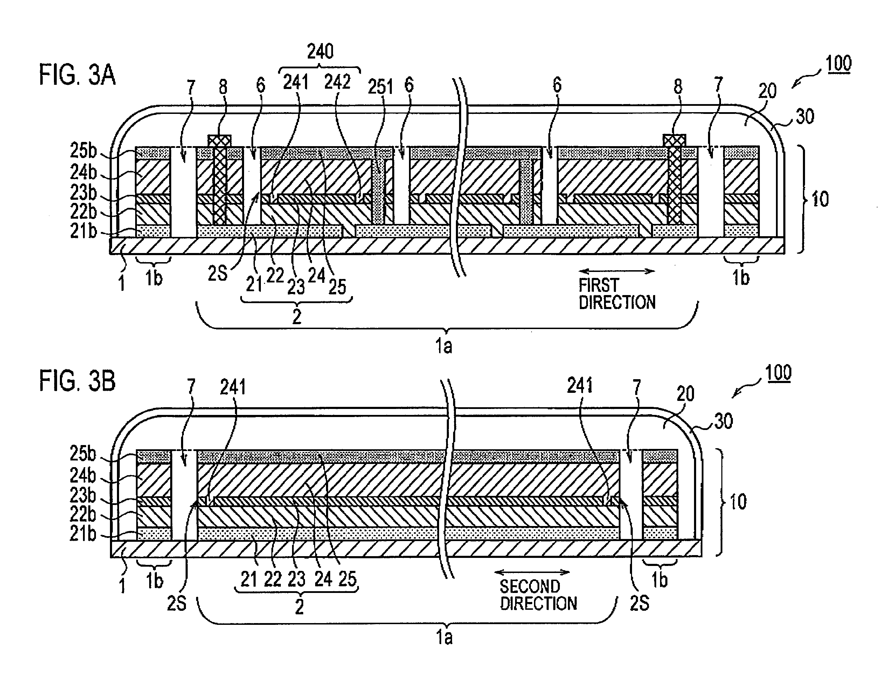

Next, with reference to Figs. 1, 2A and 2B, and 3A and 3B. the configuration of the solar cell 10 will be described.

As shown in Figs. 1, and 2A and 2B, the solar cell 10 includes a substrate 1, the power generation region 1a and the non-power generation region 1b.

As the substrate 1, transparent glass, plastic or the like can be used.

The power generation region 1a and the non-power generation region 1b are formed on a principal surface of the substrate 1. As shown in Fig. 1, the non-power generation region 1 b is formed along a periphery of the power generation region 1a. The power generation region 1a and the non-power generation region 1b are separated from each other by a power generation region separation groove 7.

The power generation region 1a includes the plurality of solar cell elements 2 and extraction electrodes 8 for extracting photogenerated carriers generated by the plurality of solar cell elements 2.

The plurality of solar cell elements 2 have a rectangular shape in a planar view and are arranged along a short side direction (a first direction in Figs) on the substrate 1. The plurality of solar cell elements 2 are electrically connected in series. As shown in Figs 2A and 2B, each of the plurality of solar cell elements 2 includes a first electrode layer 21, a first semiconductor layer 22, a transparent conductive layer 23, a second semiconductor layer 24 and a second electrode layer 25, which are sequentially stacked from the side of the substrate 1. Each of the plurality of solar cell elements 2 generates photogenerated carriers by use of light entered toward the second electrode layer 25 from the first electrode layer 21. The plurality of solar cell elements 2 are separated from each other by an element separation groove 6. Therefore, each of the plurality of solar cell elements 2 is surrounded by the element separation groove 6 and the power generation region separation groove 7. Note that the element separation groove 6 is a penetration groove penetrating the first semiconductor layer 22, the transparent conductive layer 23, the second semiconductor layer 24, and the second electrode layer 25. And note that the power generation region separation groove 7 is a penetration groove penetrating the first electrode layer 21, the first semiconductor layer 22, the transparent conductive layer 23, the second semiconductor layer 24, and the second electrode layer 25. The first electrode layer 21 is stacked on the principal surface of the substrate 1 and has conductive and transparent properties. As the first electrode layer 21, a metal oxide can be used, such as tin oxide (SnO₂), zinc oxide (ZnO), indium oxide (In₂O₃) and titanium oxide (TiO₂). Note that the metal oxides described above may be doped with fluorine (F), tin (Sn). aluminum (Al), iron (Fe), gallium (Ga), niobium (Nb) or the like.

The first semiconductor layer 22 generates photogenerated carriers by use of light entered from the first electrode layer 21 and light reflected from the transparent conductive layer 23. The first semiconductor layer 22 has a p-i-n junction (not shown) in which a p-type semiconductor, an i-type amorphous silicon semiconductor and an n-type semiconductor are sequentially stacked from the side of the substrate 1.

The transparent conductive layer 23 has transparent and conductive properties, transmits a part of the light transmitted through the first semiconductor layer 22 to the second semiconductor layer 24 and reflects a part of the light transmitted through the first semiconductor layer 22 back to the first semiconductor layer 22. As the transparent conductive layer 23, a metal oxide such as ZnO, ITO and TiOx can be used. The transparent conductive layer 23 may be doped with a dopant such as Al. Moreover, as the transparent conductive layer 23, a thin metal layer, a thin semiconductor layer, a combination of a thin insulating layer and a conductive layer, or the like can be used.

The second semiconductor layer 24 generates photogenerated carriers by use of light transmitted through the first electrode layer 21, the first semiconductor layer 22 and the transparent conductive layer 23 among the light that has entered from the first electrode layer 21 side. The second semiconductor layer 24 has a p-i-n junction (not shown) in which a p-type semiconductor, an i-type microcrystalline silicon semiconductor and an n-type semiconductor are sequentially stacked from the side of the substrate 1.

As shown in Fig 2, the second semiconductor layer 24 has an extension part 240 extended toward the first semiconductor layer 22. The extension part 240 is formed to surround side surface of the transparent conductive layer 23. More specifically, the extension part 240 includes first extension part 241 and a second extension part 242.

The first extension part 241 is extended andin contact with the first semiconductor layer 22 with passing side of the transparent conductive layer 23. The first extension part 241 is formed to be in contact with the pair of element separation grooves 6 along second direction. Moreover, The first extension part 241 is formed to be in contact with the power generation region separation groove 7 along the first direction. Both ends of the first extension part 241 (not shown) are connected to both ends of the second extension part 242.

The first extension part 241 is preferably, but not necessarily. exposed to a side surface 2S of the solar cell element 2, as shown in Figs. 2A and 2B.

The second extension part 242 is extended and in contact with the first semiconductor layer 22 with passing side of the transparent conductive layer 23 The second extension part 242 is provided along the connection part 251 to be described later.

The second electrode layer 25 is formed on the second semiconductor layer 24. As the second electrode layer 25, ITO having conductivity, silver (Ag) or the like can be used. However, the second electrode layer 25 is not limited thereto. For example, the second electrode layer 25 may have a configuration in which a layer containing ITO and a layer containing Ag are sequentially stacked on the second semiconductor layer 24.

The second electrode layer 25 has the connection part 251. The connection part 251 in one solar cell element 2 included in the plurality of solar cell elements 2 is in contact with a first electrode layer 21 in another solar cell element 2 adjacent to the one solar cell element 2. The one solar cell element 2 and the another solar cell element 2 are electrically connected in series by the connection part 251 as described above.

The non-power generation region 1b has a configuration in which a first electrode layer 21 b, a first semiconductor layer 22b, a transparent conductive layer 23b, a second semiconductor layer 24b and a second electrode layer 25b are sequentially stacked on the substrate 1. Materials forming the first electrode layer 21 b, the first semiconductor layer 22b, the transparent conductive layer 23b, the second semiconductor layer 24b and the second electrode layer 25b are the same as those forming the first electrode layer 21, the first semiconductor layer 22, the transparent conductive layer 23, the second semiconductor layer 24 and the second electrode layer 25 of the solar cell element 2. However, the non-power generation region 1 b does not contribute to power generation.

### (Method for Manufacturing Solar Cell Module)

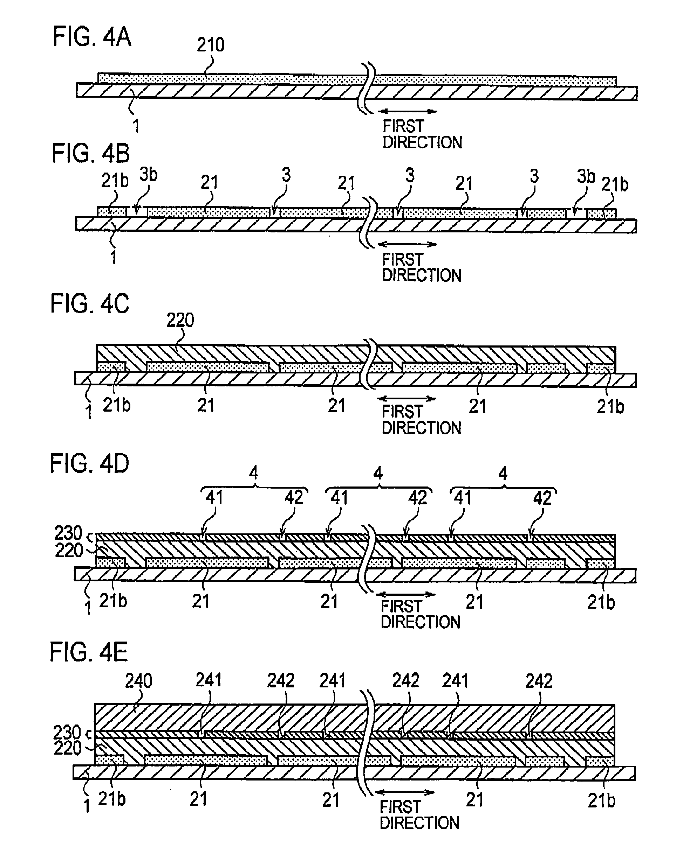

Next, with reference to Figs. 4A to 4E, 5A to 5D, 6A and 6B, and 7, description will be given of a method for manufacturing the solar cell module 100 according to the first embodiment of the present invention.

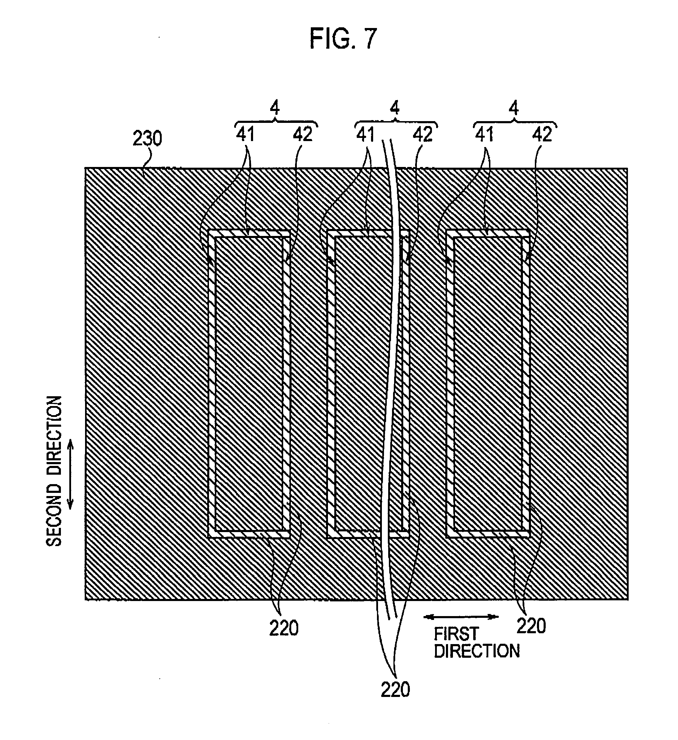

Figs. 4A to 4E, 5A to 5D, 6A and 6B are views showing manufacturing processes of the solar cell module 100. Moreover, Fig. 7 is a plan view of a third layer 230 to be described later.

First, as shown in Fig. 4A, a first layer 210 is formed by stacking a metal oxide such as ZnO, ITO, TiOx, and the like on a principal surface of a substrate 1.

Next, as shown in Fig. 4B, first electrode separation grooves 3 and first electrode separation grooves 3b are formed by removing a part of the first layer 210 with laser beam irradiation. Accordingly, with the event described above, the first electrode layers 21 and the first electrode layers 21 b are formed. Note that the first electrode layers 21 and the first electrode layers 21 b may be formed at positions excluding the first electrode separation grooves 3 and the first electrode separation grooves 3b by use of a mask.

Thereafter, as shown in Fig. 4C, a second layer 220 is formed by stacking a p-type semiconductor, an i-type microcrystalline silicon semiconductor and an n-type semiconductor on the first electrode layer 21 and inside of the first electrode separation grooves 3. Subsequently, as shown in Fig. 4D, the third layer 230 having transparent conductive layer separation grooves 4 is formed by stacking a metal oxide such as ZnO, ITO, TiOx, and the like on the second layer 220. The transparent conductive layer separation grooves 4 are formed in a rectangular shape in planar view. More specifically, as shown in Fig. 7, each of the transparent conductive layer separation grooves 4 include a first transparent conductive layer separation groove 41 formed in a rectangular shape and a second transparent conductive layer separation groove 42 formed linearly along a second direction.

The third layer 230 can be formed by use of the following two formation methods. A first formation method includes stacking the metal oxide on the second layer 220 and removing a part of the stacked metal oxide with laser beam irradiation. A second formation method includes removing a mask provided in a shape of the transparent conductive layer separation grooves 4 after stacking the metal oxide.

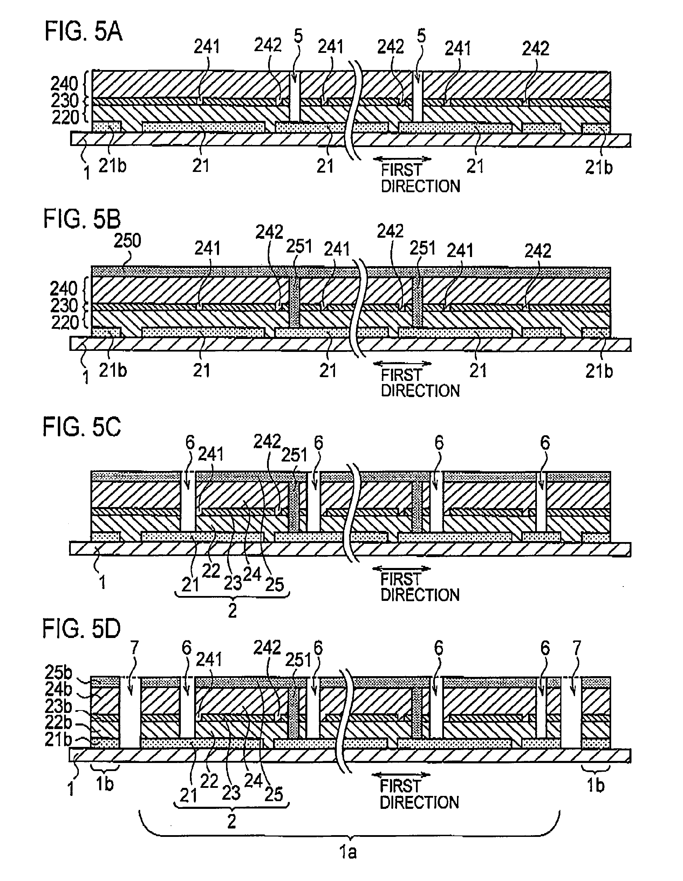

The each of the transparent conductive layer separation grooves 4 is formed astride between upper side of the first electrode layer 21 and upper side of another first electrode layer 21 adjacent to the first electrode layer 21. Also, the each of the transparent conductive layer separation grooves 4 is provided in a region surrounded by connection grooves 5 (see Fig. 5A) and element separation grooves 6 (see Fig. 5C) to be described later.

Next, as shown in Fig. 4E, a fourth layer 240 is formed by stacking a p-type semiconductor, an i-type microcrystalline silicon semiconductor and an n-type semiconductor on the third layer 230 and inside of the transparent conductive layer separation grooves 4. In this event, a first extension part 241 is formed by the fourth layer 240 filled inside the first transparent conductive layer separation groove 41. Moreover, a second extension part 242 is formed by the fourth layer 240 filled inside the second transparent conductive layer separation groove 42.

Thereafter, as shown in Fig. 5A, the second layer 220, the third layer 230 and the fourth layer 240 are partially removed along the second direction with laser beam irradiation. Thus, the connection grooves 5 are formed, which separate the second layer 220, the third layer 230 and the fourth layer 240. In between one of the transparent conductive layer separation grooves 4 and adjacent one of the transparent conductive layer separation grooves 4, each of the connection groove 5 is preferably formed adjacent to the second transparent conductive layer separation groove 42. A bottom surface of the connection groove 5 is a surface of the first electrode layer 21.

Subsequently, as shown in Fig. 5B, a fifth layer 250 is formed by stacking a conductive material on the fourth layer 240 and inside of the connection grooves 5. In this event, a connection part 251 is formed with each of the connection grooves filled with the conductive material.

Next, as shown in Fig. 5C. the element separation grooves 6 are formed by removing the second layer 220, the third layer 230, the fourth layer 240 and the fifth layer 250 partially along the second direction with laser beam irradiation. The element separation grooves 6 separates the second layer 220, the third layer 230, the fourth layer 240 and the fifth layer 250. Accordingly, a first semiconductor layer 22, a transparent conductive layer 23, a second semiconductor layer 24 and a second electrode layer 25 in the solar cell element 2 are formed.

Each of the element separation grooves 6 is preferably formed adjacent to the first extension part 241. Here, it is preferable that, the first extension part 241 is exposed on a side surface of the each of the element separation grooves 6 so that the transparent conductive layer 23 in the solar cell element 2 is not exposed on a side surface 2S of the solar cell element 2.. A bottom surface of the element separation groove 6 is the surface of the first electrode layer 21.

Next, as shown in Fig. 5D, the power generation region separation groove 7 is formed by removing the second layer 220, the third layer 230, the fourth layer 240 and the fifth layer 250 along the first electrode separation groove 3b with laser beam irradiation. The power generation region separation groove 7 separates the power generation region 1 a from the non-power generation region 1b.

The power generation region separation groove 7 is preferably formed adjacent to the first extension part 241. Here. it is preferable that the first extension part is exposed on a side surface of the power generation region separation groove 7 so that the transparent conductive layer 23 is not exposed on a side surface of the power generation region separation groove 7, which is the side surface of 2S of the solar cell element 2. A bottom surface of the power generation region separation groove 7 is the surface of the substrate 1.

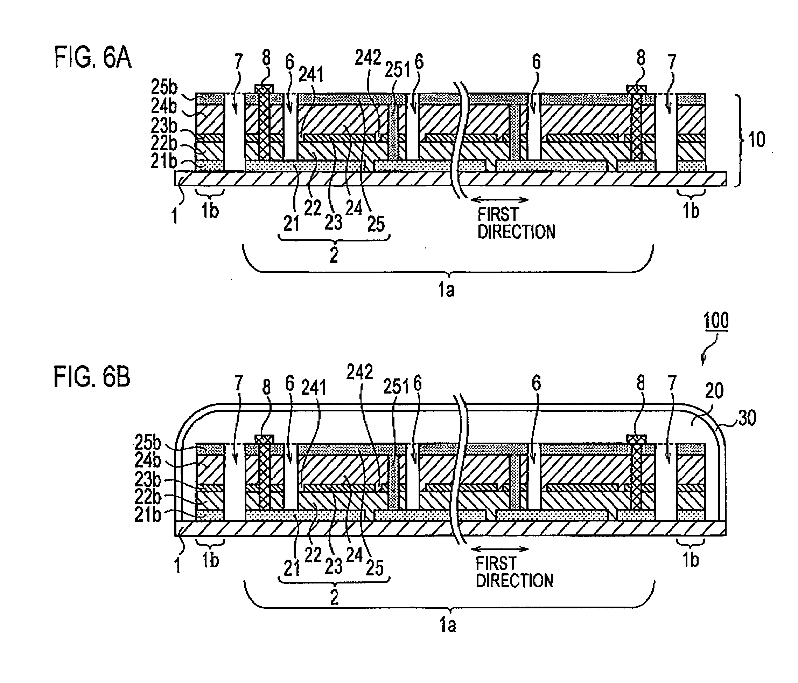

Thereafter, as shown in Fig. 6A. extraction electrodes 8 are disposed at ends of the power generation region 1a. Thus, a solar cell 10 is formed.

Subsequently, as shown in Fig. 6B, a filler 20 and a protector 30 are sequentially disposed so as to cover the power generation region 1a and the non-power generation region 1 b of the solar cell 10. Note that, by this step, the filler 20 is filled inside the element separation grooves 6 and the power generation region separation grooves 7. Thus, the solar cell module 100 is manufactured.

### (Advantageous Effects)

In the solar cell element 2 according to the first embodiment of the present invention, the second semiconductor layer 24 includes the first extension part 241 which is extended toward the first semiconductor layer 22. The first extension part 241 is provided along the element separation groove 6 and the power generation region separation groove 7 and covers a side surface of the transparent conductive layer 23. The first extension part 241 as described above covers the side surface of the transparent conductive layer 23. Thus, the transparent conductive layer 23 is not exposed to the side surface of the element separation groove 6 and the power generation region separation groove 7. Consequently, even if moisture in the protector 30 and the filler 20 enters the element separation grooves 6 or the power generation region separation grooves 7, the transparent conductive layer 23 can be prevented from coming into direct contact with the moisture. Therefore. deterioration of the transparent conductive layer 23 can be suppressed.

The second extension part 242 is provided along the connection part 251. Consequently, leakages of photogenerated carriers generated in the solar cell element 2 from the transparent conductive layer 23 into the connection part 251 can be suppressed.

Note that the connection part 251 is provided between the second extension part 242 and the other element separation groove 6.. Therefore, moisture in the filler filled in the other element separation groove 6 is blocked by the connection part 251. Thus, the moisture in the filler filled in the other element separation groove 6 is prevented from reaching the transparent conductive layer 23.

### [Second Embodiment]

A second embodiment of the present invention will be described below. Note that the following description will be mainly given of differences between the first embodiment described above and the second embodiment.

### (Configuration of Solar Cell)

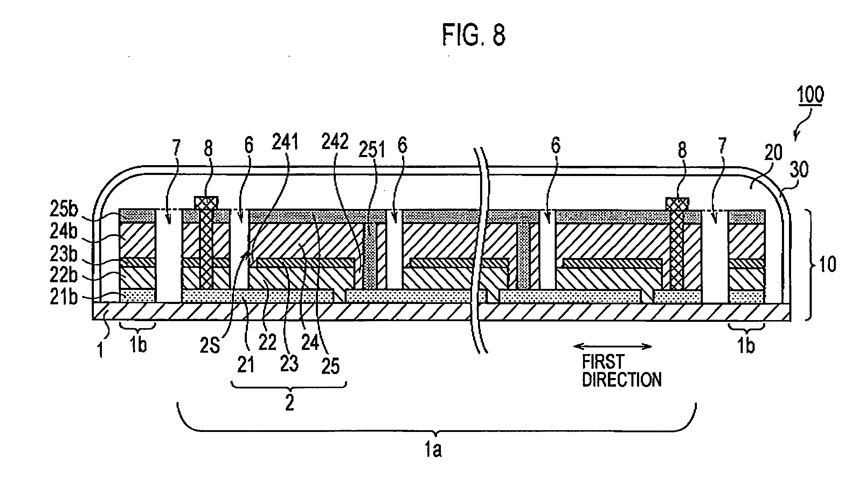

Fig. 8 is a cross-sectional view of a solar cell module 100 according to the second embodiment of the present invention. As shown in Fig. 8, a second semiconductor layer 24 has a first extension part 241 and a second extension part 242.

In the second embodiment, the second extension part 242 is extended toward the first electrode layer 21 and is in contact with the first electrode layer 21. In other words, the second extension part 242 is formed between the first semiconductor layer 22 and a connection part 251.

### (Advantageous Effects)

The second semiconductor layer 24 according to the second embodiment of the present invention is extended toward the first electrode layer 21 and is in contact with the first electrode layer 21. Consequently, leakages of photogenerated carriers generated in the first semiconductor layer 22, which leaks from the transparent conductive layer 23 into the connection part 251, can be suppressed.

### [Third Embodiment]

A third embodiment of the present invention will be described below. Note that the following description will be mainly given of differences between the first embodiment described above and the third embodiment

### (Configuration of Solar Cell)

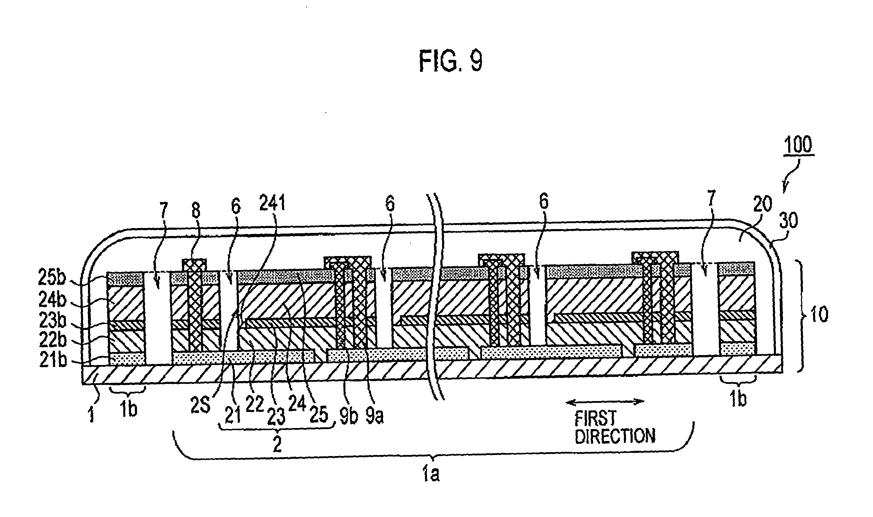

Fig. 9 is a cross-sectional view of a solar cell module 100 according to the third embodiment of the present invention. As shown in Fig. 9, the solar cell element 2 has a conductive part 9a and an insulating part 9b.

The conductive part 9a in one solar cell element 2 is in contact with a first electrode layer 21 in abother solar cell element 2 adjacent to the one solar cell element 2. The one and another as described above. Specifically, the conductive part 9a has the same function as that of the connection part 251 according to the first embodiment of the present invention. As the conductive part 9a. a metal material having conductivity or the like can be used. However, the conductive part 9a is not limited thereto.

The insulating part 9b is provided between a transparent conductive layer 23 and the conductive part 9a. With the insulating part 9b as described above, leakages of photogenerated carriers generated in the solar cell element 2, which leaks into the conductive part 9a along the transparent conductive layer 23, can be surppressed. In other words, the insulating part 9b has the same function as that of the second extension part 242 according to the first embodiment of the present invention. As the insulating part 9b, a material having insulating properties can be used.

### [Fourth Embodiment]

A fourth embodiment of the present invention will be described below. Note that the following description will be mainly given of differences between the first embodiment described above and the fourth embodiment.

Specifically, in the first embodiment described above, each of the plurality of solar cell elements 2 generates photogenerated carriers by use of the light entered toward the second electrode layer 25 from the first electrode layer 21.

Meanwhile, in the fourth embodiment, each of the plurality of solar cell elements 2 generates photogenerated carriers by use of light entered toward a first electrode layer 21 from a second electrode layer 25. Specifically, in the fourth embodiment, the first electrode layer 21, a second semiconductor layer 24, a transparent conductive layer 23, a first semiconductor layer 22, and the second electrode layer 25 are sequentially stacked on a substrate 1.

### (Configuration of Solar Cell)

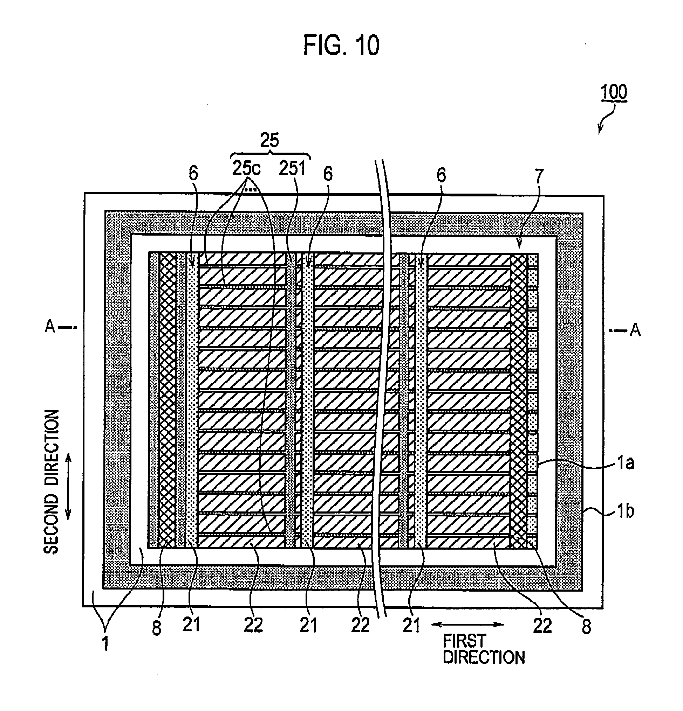

Fig. 10 is a top view of a solar cell module 100 according to the fourth embodiment of the present invention.

As shown in the Fig. 10, the second electrode layer 25 has a plurality of grid electrodes 25c and a connection part 251. The plurality of grid electrodes 25c are provided so as to have an area as small as possible to increase an amount of light absorbed by the second semiconductor layer 22. For example, as shown in Fig. 10, it is preferable that each of the plurality of grid electrode 25c is formed by reducing an electrode width. Between the plurality of grid electrodes 25c, the first semiconductor layer 22 is exposed. The connection part 251 electrically connects the adjacent solar cell elements 2 in series. The plurality of grid electrodes 25c and the connection part 251 can be formed by use of resin conductive paste containing a resin material as a binder and conductive particles such as silver particles as filler. However, the plurality of grid electrodes 25c and the connection part 251 are not limited thereto.

As described above, the present invention can be applied to a type of solar cell module which uses light entered from the second electrode layer 25.

### (Other Embodiments)

The present invention has been described through the above embodiments. However, it should be understood that the present invention is not limited to the description and drawings which constitute a part of this disclosure. From this disclosure, various alternative embodiments, examples and operational technologies will become apparent to those skilled in the art.

In the embodiments described above, the second semiconductor layer 24 has the second extension part 242. However, the second semiconductor layer 24 does not have to have the second extension part 242.

Moreover, in the first embodiments described above, the side surface of the transparent conductive layer 23 is surrounded by the first extension part 241 and the second extension part 242. However, the transparent conductive layer 23 does not have to be surrounded completely by the first extension part 241 and the second extension part 242. Moreover, in the embodiments described above, two semiconductor layers are included in each of the solar cell elements 2. However, the number of the semiconductor layers is not limited to two. Specifically, three or more semiconductor layers may be included in the solar cell element 2. In such a case, the solar cell element 2 may be provided between the second semiconductor layer 24 and the second electrode layer 25, and includes a third semiconductor layer including a extension part which is in contact with the first semiconductor layer 22.

Moreover, in the embodiments described above, the first semiconductor layer 22 and the second semiconductor layer 24 have the p-i-n junctions. However, the present invention is not limited thereto. Specifically, at least one of the first semiconductor layer 22 and the second semiconductor layer 24 may have a p-n junction.

Moreover, in the embodiments described above, the first semiconductor layer 22 and the second semiconductor layer 24 are mainly made of silicon. However, the present invention is not limited thereto but other semiconductor materials can be used. Specifically, a power generation region of one of the first semiconductor layer 22 and the second semiconductor layer 24, which is positioned at the light incidence side, is formed of a wide band gap material and a power generation region of the other semiconductor layer positioned at the light transmission side is formed of a narrow band gap material.

As described above, the present invention includes various embodiments and the like which are not described herein, as a matter of course. Therefore, a technological scope of the present invention is defined only by items specific to the invention according to claims pertinent based on the foregoing description.

### [Example]

A solar cell according to the present invention will be concretely described below by means of the following examples. However, the present invention is not limited to the following examples but can be carried out by making appropriate changes without departing from the scope of the invention.

### (Example)

A solar cell 110 according to an example was manufactured as described below.

First, a SnO₂ layer (a first electrode layer 21) having a concavo-convex structure was formed on a glass substrate (a substrate 1).

Next, on the SnO₂ layer (the first electrode layer 21), a first cell (a first semiconductor layer 22) was formed by use of a P-CVD method. Specifically, the first cell (the first semiconductor layer 22) was formed by sequentially stacking a p-type amorphous silicon semiconductor, an i-type amorphous silicon semiconductor and an n-type amorphous silicon semiconductor. A thickness of the first cell (the first semiconductor layer 22) was set to 180 nm.

Thereafter, on the first cell (the first semiconductor layer 22), a mask was formed along a periphery of the first cell (the first semiconductor layer 22).

Subsequently, on an exposed surface of the first cell (the first semiconductor layer 22) and on the mask, a ZnO layer (a transparent conductive layer 23) containing Al by 3 wt% as a dopant was formed by use of a sputtering method. A thickness of the ZnO layer (the transparent conductive layer 23) was set to 30 nm.

Next, the mask formed on the first cell (the first semiconductor layer 22) was removed.

Thereafter, by use of the P-CVD method, a p-type microcrystalline silicon semiconductor, an i-type microcrystalline silicon semiconductor and an n-type microcrystalline silicon semiconductor were sequentially stacked on the ZnO layer (the transparent conductive layer 23) and on the first cell (the first semiconductor layer 22) exposed by removing the mask. Thus, a second cell (a second semiconductor layer 24) was formed, which had a first extension part 241 covering a side surface of the ZnO layer (the transparent conductive layer 23). A thickness of the second cell (the second semiconductor layer 24) was set to 2000 nm.

Subsequently, by use of the sputtering method, an ITO/Ag layer (a second electrode layer 25) was formed on the second cell (the second semiconductor layer 24).

Next, extraction electrodes 8 were disposed on the SnO₂ layer (the first electrode layer 21) and the ITO/Ag layer (the second electrode layer 25).

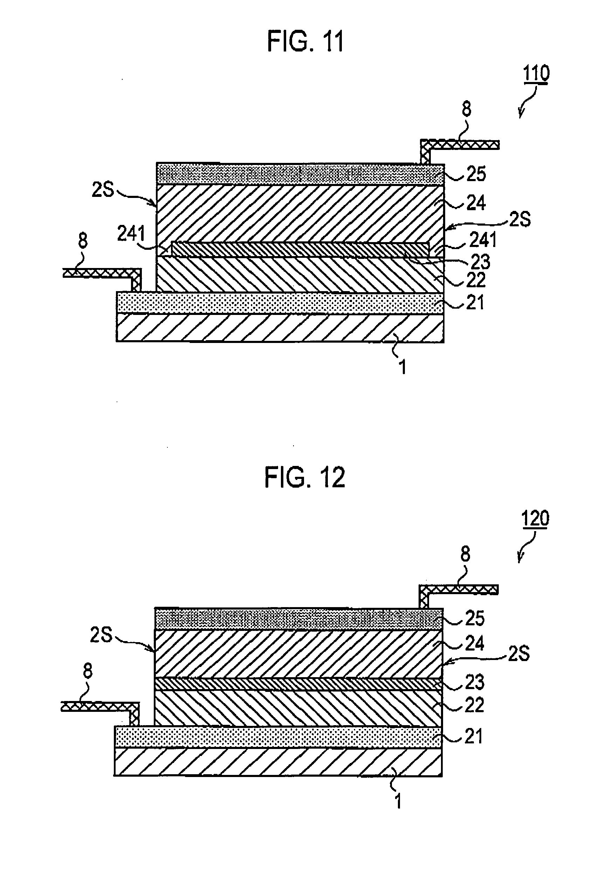

Thus, in this example, the solar cell 110 was manufactured, in which the side surface of the ZnO layer (the transparent conductive layer 23) was covered with the first extension part 241 of the second cell (the second semiconductor layer 24), as shown in Fig. 11.

### (Comparative Example)

A solar cell 120 according to a comparative example was manufactured as described below.

First, a SnO₂ layer (a first electrode layer 21) having a concavo-convex structure was formed on a glass substrate (a substrate 1).

Next, on the SnO₂ layer (the first electrode layer 21), a first cell (a first semiconductor layer 22) was formed by use of a P-CVD method. Specifically, the first cell (the first semiconductor layer 22) was formed by sequentially stacking a p-type amorphous silicon semiconductor, an i-type amorphous silicon semiconductor and an n-type amorphous silicon semiconductor. A thickness of the first cell (the first semiconductor layer 22) was set to 180 nm.

Thereafter, on the first cell (the first semiconductor layer 22), a ZnO layer (a transparent conductive layer 23) containing Al by 3 wt% as a dopant was formed by use of a sputtering method. A thickness of the ZnO layer (the transparent conductive layer 23) was set to 30 nm.

Subsequently, by use of the P-CVD method. a second cell (a second semiconductor layer 24) was formed on the ZnO layer (the transparent conductive layer 23). Specifically, a p-type microcrystalline silicon semiconductor, an i-type microcrystalline silicon semiconductor and an n-type microcrystalline silicon semiconductor were sequentially stacked. A thickness of the second cell (the second semiconductor layer 24) was set to 2000 nm.

Next, by use of the sputtering method, an ITO/Ag layer (a second electrode layer 25) was formed on the second cell (the second semiconductor layer 24).

Thereafter, extraction electrodes 8 were disposed on the SnO₂ layer (the first electrode layer 21) and the ITO/Ag layer (the second electrode layer 25).

Thus, in this comparative example, the solar cell 120 was manufactured, in which a side surface of the ZnO layer (the transparent conductive layer 23) was exposed, as shown in Fig. 12.

### (Moisture Resistance Test)

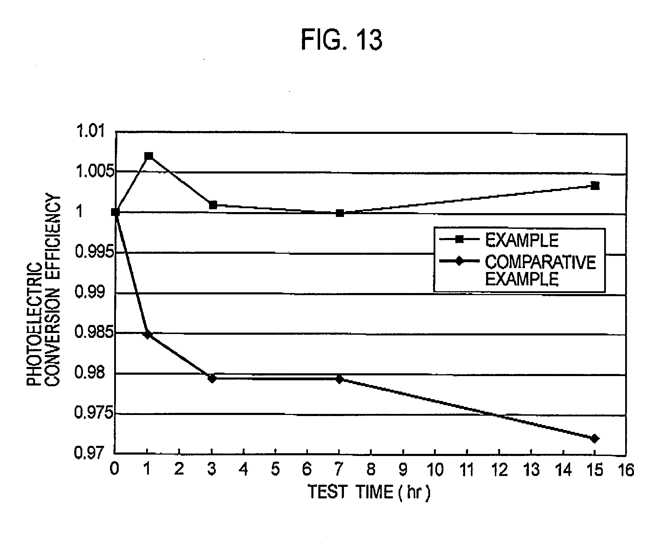

A moisture resistance test was performed on the solar cells according to the example and the comparative example described above. Fig. 13 is a graph showing changes with time in photoelectric conversion efficiency of the solar cells according to the example and the comparative example. As test a condition, a temperature was set to 85 ° C, humidity was set to 90 % and a test time was set to 15 hours. In Fig. 13, for both of the example and the comparative example, the photoelectric conversion efficiency before the moisture resistance test is presented as being standardized as 1.000. Note that, in order to distinguish influences of a temperature rise during the moisture resistance test on the photoelectric conversion efficiency, the solar cells according to the example and the comparative examples were thermally annealed at 150 ° C for 2 hours.

As shown in Fig. 13, in the solar cell 110 according to the example, the same photoelectric conversion efficiency as that before the moisture resistance test was maintained throughout the test time of 15 hours. This is because of the following reason. Specifically, in the solar cell 110 according to the example, the ZnO layer (the transparent conductive layer 23) is not exposed on the side surface of the solar cell 110. Thus, the ZnO layer (the transparent conductive layer 23) is prevented from being deteriorated by contact with moisture.

On the other hand, in the solar cell 120 according to the comparative example, the photoelectric conversion efficiency was gradually deteriorated. This is because of the following reason. Specifically, in the solar cell 120 according to the comparative example, the ZnO layer (the transparent conductive layer 23) is exposed on the side surface of the solar cell 120. Thus, the ZnO layer (the transparent conductive layer 23) is deteriorated by direct contact with moisture.

As described above, it is revealed that moisture resistance of the solar cell can be improved by forming the second cell (the second semiconductor layer 24) having the first extension part 241 covering the side surface of the ZnO layer (the transparent conductive layer 23).

## Claims

1. A solar cell module in which a first electrode layer, a first semiconductor layer, a transparent conductive layer, a second semiconductor layer and a second electrode layer are sequentially stacked on a substrate, comprising:
a plurality of solar cell elements surrounded by a penetration groove penetrating the first semiconductor layer, the transparent conductive layer, the second semiconductor layer and the second electrode layer,
wherein
in one solar cell element included in the plurality of solar cell elements, the second semiconductor layer includes an extension part which is extended toward the first semiconductor layer.
the extension part covers at least a part of side surface of the transparent conductive layer, and
the extension part is provided along the penetration groove.

2. The solar cell module according to claim 1, wherein
the penetration groovepenetration groove is a pair of element separation grooves provided on both side of each of the plurality of solar cell elements,
the second electrode layer in the one solar cell element has a connection part connecting to the first electrode layer in another solar cell element adjacent to the one solar cell element, the connection part covering a side surface of the transparent conductive layer on a side of one of the pair of element separation grooves, and
the penetrating goove is provided on another side of one of the pair of element separation groove.

3. The solar cell module according to claim 1, further comprising:
a power generation region including the plurality of solar cell elements and a non-power generation region surrounding the power generation region and being spaced apart from the power generation region,
wherein
the penetration groove is a power generation region separation groove separating the power generation region from the non-power generation region, and
the power generation region separation groove penetrates the first electrode layer, the first semiconductor layer, the transparent conductive layer, the second semiconductor layer and the second electrode layer.

4. A method for manufacturing a solar cell module in which a first electrode layer, a first semiconductor layer, a transparent conductive layer, a second semiconductor layer and a second electrode layer are sequentially stacked on a substrate, the solar cell module including a plurality of solar cell elements surrounded by a penetration groove penetrating at least the first semiconductor layer, the transparent conductive layer, the second semiconductor layer and the second electrode layer, the method comprising the steps of:
forming the first electrode layer and the first semiconductor layer sequentially on the substrate;
forming the transparent conductive layer and the second semiconductor layer including an extension part which covers at least a part of side surface of the transparent conductive layer sequentially on the first semiconductor layer; and
forming the penetration groove along the extension part,

5. The method for manufacturing a solar cell module, according to claim 4,
wherein
the step of forming the second semiconductor layer including the extension part includes the steps of:
covering a part of the first semiconductor layer with a mask;
forming the transparent conductive layer on the first semiconductor layer, removing the mask; and
forming the second semiconductor layer on the first semiconductor layer exposed in a region where the mask has been removed.

6. The method for manufacturing a solar cell module, according to claim 5,
wherein
the step of forming the second semiconductor layer including the extension part includes the steps of:
forming the transparent conductive layer on the first semiconductor layer;
removing a part of the transparent conductive layer: and
forming the second semiconductor layer on the semiconductor layer exposed in a region where the part of the transparent conductive layer has been removed.
